# EUROPEAN PATENT APPLICATION

(11) **EP 4 779 051 A1**
(43) Date of publication of application: **22.07.2026**
(21) Application number: 26150059.9
(22) Date of filing: 02.01.2026
(51) Int. Cl.: C23C 14/12, C23C 14/24

(54) **EVAPORATION SOURCE, DEPOSITION APPARATUS INCLUDING THE EVAPORATION SOURCE AND DEPOSITION METHOD USING THE DEPOSITION APPARATUS**

(30) Priority: 13.01.2025 KR 20250004684
(71) Applicant: Samsung Display Co., Ltd., Yongin-si, Gyeonggi-do 17113 (KR)
(72) Inventor: CHOI, Jong Hyun, 17113 Yongin-si, Gyeonggi-do (KR); PARK, Sung Jong, 17113 Yongin-si, Gyeonggi-do (KR); LEE, Yoon Jae, 17113 Yongin-si, Gyeonggi-do (KR); HAN, Jong Bun, 17113 Yongin-si, Gyeonggi-do (KR)
(74) Representative: Gulde & Partner

(57) **Abstract**

An evaporation source includes a main body, a deposition nozzle assembly disposed above the main body, where the deposition nozzle discharges a plurality of deposition materials, an angle limiting portion disposed above the deposition nozzle assembly, where the angle limiting portion limits a discharge angle of the plurality of deposition materials discharged from the deposition nozzle assembly, and a plurality of vaporizing portions which accommodates the plurality of deposition materials, vaporizes the plurality of deposition materials, and supplies the vaporized deposition materials to the deposition nozzle assembly.

## Description

### BACKGROUND

### 1. Field

The present disclosure relates to an evaporation source, a deposition apparatus including the evaporation source, and a deposition method using the deposition apparatus.

### 2. Description of the Related Art

An organic light emitting display device is a display device that uses a phenomenon in which electrons injected from a cathode and holes injected from an anode are recombined with each other in an organic thin film to form excitons and light of a specific wavelength is generated by energy from the formed excitons.

As a method of depositing an organic material, a metal used as an electrode, or the like, on a substrate in the organic light emitting display device, a vacuum deposition method may be used. The vacuum deposition method is a method of locating a substrate on which an organic thin film is to be formed inside a vacuum chamber, bringing a mask assembly having the same pattern as a pattern of the thin film to be formed into close contact with the substrate, and then evaporating and sublimating a deposition material such as an organic material using an evaporation source to deposit the deposition material on the substrate.

The evaporation source typically includes a crucible accommodating the deposition material and a deposition nozzle, and the deposition material may be vaporized and discharged through the deposition nozzle by heating the crucible. An angle limiting portion for limiting a discharge angle of the deposition material discharged through the deposition nozzle may be disposed above the deposition nozzle.

### SUMMARY

The invention is defined by the appended claims. The description that follows is subjected to this limitation. Any disclosure lying outside the scope of said claims is only intended for illustrative as well as comparative purposes.

Embodiments of the present disclosure provides an evaporation source capable of securing deposition uniformity of deposition materials deposited on a deposition substrate by uniformly mixing a plurality of deposition materials with each other and discharging the uniformly mixed deposition materials to the deposition substrate, a deposition apparatus including the evaporation source, and an electronic device manufactured using the deposition apparatus.

The above and other embodiments of the present disclosure will become more apparent to one of ordinary skill in the art to which the present disclosure pertains by referencing the detailed description of the present disclosure given below.

According to an embodiment of the present disclosure, an evaporation source includes a main body, a deposition nozzle assembly disposed above the main body, where the deposition nozzle is configured to discharge a plurality of deposition materials, an angle limiting portion disposed above the deposition nozzle assembly, where the angle limiting portion is configured to limit a discharge angle of the plurality of deposition materials discharged from the deposition nozzle assembly, and a plurality of vaporizing portions is configured to accommodate the plurality of deposition materials, vaporize the plurality of deposition materials, and supply the vaporized deposition materials to the deposition nozzle assembly.

In an embodiment, the deposition nozzle assembly may include a first deposition nozzle, a second deposition nozzle spaced apart from the first deposition nozzle in a first direction, a third deposition nozzle spaced apart from the second deposition nozzle in a second direction crossing the first direction, and a fourth deposition nozzle spaced apart from the first deposition nozzle in the second direction.

In an embodiment, an interval between the first deposition nozzle and the fourth deposition nozzle may be the same as an interval between the second deposition nozzle and the third deposition nozzle, and an interval between the first deposition nozzle and the second deposition nozzle may be the same as an interval between the third deposition nozzle and the fourth deposition nozzle.

In an embodiment, each of an interval between the first deposition nozzle and the fourth deposition nozzle and an interval between the second deposition nozzle and the third deposition nozzle may be smaller than each of an interval between the first deposition nozzle and the second deposition nozzle and an interval between the third deposition nozzle and the fourth deposition nozzle.

In an embodiment, the plurality of vaporizing portions may include a first vaporizing portion, a second vaporizing portion, a third vaporizing portion, and a fourth vaporizing portion, the first vaporizing portion may be connected to the first deposition nozzle, the second vaporizing may be is connected to the second deposition nozzle, the third vaporizing portion is connected to the third deposition nozzle, and the fourth vaporizing portion may be connected to the fourth deposition nozzle.

In an embodiment, the plurality of deposition materials may include a first deposition material and a second deposition material, the first deposition material may be accommodated in the first vaporizing portion and the third vaporizing portion, and the second deposition material may be accommodated in the second vaporizing portion and the fourth vaporizing portion.

In an embodiment, an angle limiting hole, through which the plurality of deposition materials passes, may be defined in the angle limiting portion, and the first deposition nozzle, the second deposition nozzle, the third deposition nozzle, and the fourth deposition nozzle may overlap the angle limiting hole in a third direction crossing the first direction and the second direction.

In an embodiment, the plurality of deposition materials may include a first deposition material, a second deposition material, a third deposition material, and a fourth deposition material, the first deposition material may be accommodated in the first vaporizing portion, the second deposition material may be accommodated in the second vaporizing portion, the third deposition material may be accommodated in the third vaporizing portion, and the fourth deposition material may be accommodated in the fourth vaporizing portion.

In an embodiment, a plurality of angle limiting holes, through which the plurality of deposition materials passes, may be defined in the angle limiting portion, and the first deposition nozzle and the fourth deposition nozzle may overlap one of the plurality of angle limiting holes in a third direction crossing the first direction and the second direction, and the second deposition nozzle and the third deposition nozzle may overlap another one of the plurality of angle limiting holes in the third direction.

In an embodiment, the deposition nozzle assembly may be provided in plural, and a plurality of deposition nozzle assemblies may be arranged along the second direction.

In an embodiment, the angle limiting portion may be provided in plural, and each of a plurality of angle limiting portions may be disposed above a corresponding one of the plurality of deposition nozzle assemblies.

In an embodiment, the plurality of vaporizing portions may be spaced apart from the main body.

According to an embodiment of the present disclosure, a deposition apparatus includes a chamber, a substrate holder disposed inside the chamber, where the substrate holder supports a substrate, a mask assembly disposed below the substrate, and an evaporation source as mentioned above which is configured to discharge a plurality of deposition materials to the mask assembly. The substrate may be a substrate of a display device.

According to another aspect of the present invention, there is provided a deposition process comprising the steps of:
a) providing a deposition apparatus comprising:
   a chamber;
   a substrate holder disposed inside the chamber, wherein the substrate holder supports a substrate;
   a mask assembly disposed below the substrate; and
   an evaporation source configured for discharging a plurality of deposition materials to the mask assembly, wherein the evaporation source includes:
      a main body;
      a deposition nozzle assembly disposed above the main body, wherein the deposition nozzle assembly discharges the plurality of deposition materials;
      an angle limiting portion disposed above the deposition nozzle assembly, wherein the angle limiting portion limits a discharge angle of the plurality of deposition materials discharged from the deposition nozzle assembly; and
      a plurality of vaporizing portions which accommodates the plurality of deposition materials, vaporizes the plurality of deposition materials, and supplies the vaporized deposition materials to the deposition nozzle assembly,
      wherein the plurality of vaporizing portions includes a first vaporizing portion, a second vaporizing portion, a third vaporizing portion, and a fourth vaporizing portion,
      the first vaporizing portion is connected to the first deposition nozzle,
      the second vaporizing portion is connected to the second deposition nozzle,
      the third vaporizing portion is connected to the third deposition nozzle, and
      the fourth vaporizing portion is connected to the fourth deposition nozzle, and
      wherein the plurality of deposition materials includes a first deposition material, a second deposition material, a third deposition material, and a fourth deposition material,
      the first deposition material is accommodated in the first vaporizing portion,
      the second deposition material is accommodated in the second vaporizing portion,
      the third deposition material is accommodated in the third vaporizing portion,
      the fourth deposition material is accommodated in the fourth vaporizing portion,
      wherein a plurality of angle limiting holes, through which the plurality of deposition materials passes, is defined in the angle limiting portion, and
      the first deposition nozzle and the fourth deposition nozzle overlap one of the plurality of angle limiting holes in a third direction crossing the first direction and the second direction, and
      the second deposition nozzle and the third deposition nozzle overlap another one of the plurality of angle limiting holes in the third direction; and
b) moving the substrate in the first direction above the evaporation source, and
   forming a first deposition layer on a lower portion of the substrate by the first deposition material and the fourth deposition material respectively discharged from the first deposition nozzle and the fourth deposition nozzle, and
   forming a second deposition layer on a lower portion of the first deposition layer by the second deposition material and the fourth deposition material respectively discharged from the second deposition nozzle and the third deposition nozzle.

According to an embodiment of the present disclosure, an electronic device includes a display device manufactured by a deposition apparatus. In such an embodiment, the deposition apparatus includes a chamber, a substrate holder disposed inside the chamber, where the substrate holder supports a substrate, a mask assembly disposed below the substrate, and an evaporation source which discharges a plurality of deposition materials to the mask assembly. In such an embodiment, the evaporation source includes a main body, a deposition nozzle assembly disposed above the main body, where the deposition nozzle assembly discharges the plurality of deposition materials, an angle limiting portion disposed above the deposition nozzle assembly, where the angle limiting portion limits a discharge angle of the plurality of deposition materials discharged from the deposition nozzle assembly, and a plurality of vaporizing portions which accommodates the plurality of deposition materials, vaporizes the plurality of deposition materials, and supplies the vaporized deposition materials to the deposition nozzle assembly.

In an embodiment, the electronic device further includes at least one selected from a processor, a memory which stores data of the display device or the processor, and a power module which supplies power to the display device, the processor, or the memory.

In embodiments of a deposition apparatus including an evaporation source, and an electronic device manufactured using the deposition apparatus according to the present disclosure, there is an effect of securing deposition uniformity of deposition materials deposited on a deposition substrate by uniformly mixing a plurality of deposition materials with each other and discharging the uniformly mixed deposition materials to the deposition substrate.

The effects according to embodiments of the present disclosure are not limited to those mentioned above and more various effects are included in the following description of the present disclosure.

### BRIEF DESCRIPTION OF THE DRAWINGS

The above and other features of embodiments of the present disclosure will become more apparent by describing in detail embodiments thereof with reference to the accompanying drawings, in which:
FIG. 1 is a schematic view illustrating a deposition apparatus according to an embodiment of the present disclosure;
FIG. 2 is a schematic cross-sectional view illustrating a deposition substrate for depositing a deposition material using the deposition apparatus according to an embodiment of the present disclosure;
FIG. 3 is a cross-sectional view illustrating a state in which the deposition material is deposited in FIG. 2;
FIG. 4 is a schematic plan view for describing a mask assembly of FIG. 1;
FIG. 5 is a schematic plan view for describing cell regions and a grid region illustrated in FIG. 4;
FIG. 6 is a schematic cross-sectional view taken along line I-I' of FIG. 5;
FIG. 7 is a plan view of an evaporation source according to an embodiment of the present disclosure;
FIG. 8 is a cross-sectional view taken along line A-A' of FIG. 7;
FIGS. 9 and 10 are views illustrating a state of depositing deposition materials on the deposition substrate using the evaporation source according to an embodiment of the present disclosure;
FIG. 11 is a plan view of an evaporation source according to another embodiment of the present disclosure;
FIG. 12 is a cross-sectional view taken along line B-B' of FIG. 11;
FIGS. 13 and 14 are views illustrating a state of depositing deposition materials on the deposition substrate using the evaporation source according to another embodiment of the present disclosure;
FIG. 15 is a block diagram of an electronic device according to an embodiment; and
FIG. 16 is schematic views of electronic devices according to various embodiments.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the present disclosure will be described in detail with reference to the accompanying drawings.

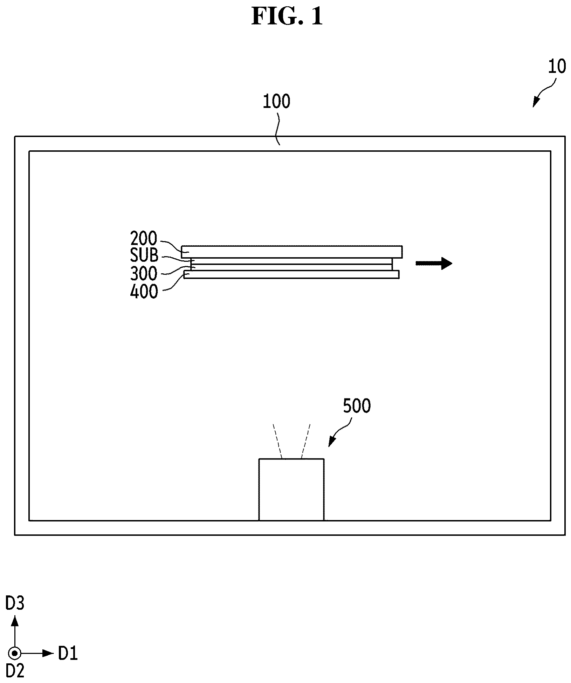

FIG. 1 is a schematic view illustrating a deposition apparatus according to an embodiment of the present disclosure.

Referring to FIG. 1, a deposition apparatus 10 according to an embodiment of the present disclosure may deposit organic materials or metals used to form electrodes on a deposition substrate SUB. The deposition apparatus 10 includes a chamber 100, a substrate holder 200, a mask assembly 300, a mask stage 400, and an evaporation source 500.

The chamber 100 may provide or define a space for performing a deposition process. An inner portion of such a chamber 100 may be maintained as a vacuum during a period in which the deposition process is performed. Maintaining the inner portion of the chamber 100 as the vacuum may mean maintaining the inner portion of the chamber 100 in a low pressure state. The chamber 100 may include an inlet/outlet (not illustrated) for carrying in/out the deposition substrate SUB.

In addition, the chamber 100 may include a vacuum pump (not illustrated) for controlling a pressure inside the chamber 100 and exhausting a deposition material that is not deposited on the deposition substrate SUB and an exhaust port (not illustrated) connected to the vacuum pump.

The substrate holder 200 supports the deposition substrate SUB. The substrate holder 200 is disposed inside the chamber 100. In an embodiment, the substrate holder 200 may be disposed at an upper side inside the chamber 100 (i.e., an upper portion of an inner space of the chamber 100), and the deposition substrate SUB may be secured on a lower portion (or attached to a lower surface) of the substrate holder 200 and supported by the substrate holder 200.

In addition, the substrate holder 200 may include a fixing member (not illustrated). The fixing member may assist in fixing the deposition substrate SUB and the mask assembly 300, and may serve to keep a distance between the deposition substrate SUB and the mask assembly 300 constant. The fixed member may be provided as a detachable frame structure.

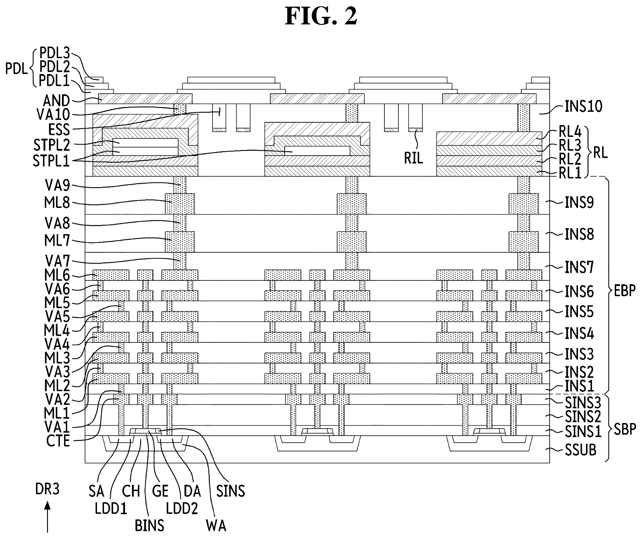

FIG. 2 is a schematic cross-sectional view illustrating a deposition substrate for depositing a deposition material using the deposition apparatus according to an embodiment of the present disclosure.

Referring to FIG. 2, in an embodiment, the deposition substrate SUB may include a semiconductor backplane SBP, a light emitting element backplane EBP, a reflective electrode layer RL, and a pixel defining film PDL.

The semiconductor backplane SBP includes a semiconductor substrate SSUB including a plurality of pixel transistors, a plurality of semiconductor insulating films covering the plurality of pixel transistors, and a plurality of contact terminals CTE electrically connected to the plurality of pixel transistors, respectively.

The semiconductor substrate SSUB may be a silicon substrate, a germanium substrate, or a silicon-germanium substrate. The semiconductor substrate SSUB may be a substrate doped with first-type impurities. A plurality of well regions WA may be disposed in an upper surface of the semiconductor substrate SSUB. The plurality of well regions WA may be regions doped with second-type impurities. The second-type impurities may be different from the first-type impurities described above. In an embodiment, for example, the first-type impurities may be p-type impurities, and the second-type impurities may be n-type impurities. Alternatively, the first-type impurities may be n-type impurities, and the second-type impurities may be p-type impurities.

Each of the plurality of well regions WA includes a source region SA corresponding to a source electrode of the pixel transistor, a drain region DA corresponding to a drain electrode of the pixel transistor, and a channel region CH disposed between the source region SA and the drain region DA.

A bottom insulating film BINS may be disposed between a gate electrode GE and the well region WA. Side surface insulating films SINS may be disposed on side surfaces of the gate electrode GE. The side surface insulating films SINS may be disposed on the bottom insulating film BINS.

Each of the source region SA and the drain region DA may be a region doped with the first-type impurities. The gate electrode GE of the pixel transistor may overlap the well region WA in a third direction DR3, which is a thickness direction of the deposition substrate SUB or the semiconductor substrate SSUB. The channel region CH may overlap the gate electrode GE in the third direction DR3. The source region SA may be disposed on one side of the gate electrode GE, and the drain region SA may be disposed on an opposing side of the gate electrode GE.

Each of the plurality of well regions WA further includes a first low-concentration impurity region LDD 1 disposed between the channel region CH and the source region SA and a second low-concentration impurity region LDD2 disposed between the channel region CH and the drain region DA. The first low-concentration impurity region LDD 1 may be a region having a lower impurity concentration than the source region SA due to the bottom insulating film BINS. The second low-concentration impurity region LDD2 may be a region having a lower impurity concentration than the drain region DA due to the bottom insulating film BINS. A distance between the source region SA and the drain region DA may increase by the first low-concentration impurity region LDD1 and the second low-concentration impurity region LDD2. Therefore, a length of the channel region CH of each of the pixel transistors may increase, and thus, punch-through and hot carrier phenomena caused by a short channel may be effectively prevented.

A first semiconductor insulating film SINS1 may be disposed on the semiconductor substrate SSUB. The first semiconductor insulating film SINS1 may include or be formed of a silicon carbonitride (SiCN) or silicon oxide (SiOₓ)-based inorganic film, but an embodiment of the present disclosure is not limited thereto.

A second semiconductor insulating film SINS2 may be disposed on the first semiconductor insulating film SINS1. The second semiconductor insulating film SINS2 may include or be formed of a silicon oxide (SiOₓ)-based inorganic film, but an embodiment of the present disclosure is not limited thereto.

The plurality of contact terminals CTE may be disposed on the second semiconductor insulating film SINS2. Each of the plurality of contact terminals CTE may be connected to a corresponding one of the gate electrode GE, the source region SA, and the drain region DA of each of the pixel transistors through a hole penetrating (i.e., formed or defined through) the first semiconductor insulating film SINS1 and the second semiconductor insulating film SINS2. Each of the plurality of contact terminals CTE may include or be made of at least one selected from copper (Cu), aluminum (Al), tungsten (W), molybdenum (Mo), chromium (Cr), gold (Au), titanium (Ti), nickel (Ni), and neodymium (Nd), or alloys thereof.

A third semiconductor insulating film SINS3 may be disposed on side surfaces of each of the plurality of contact terminals CTE. An upper surface of each of the plurality of contact terminals CTE may be exposed without being covered by the third semiconductor insulating film SINS3. The third semiconductor insulating film SINS3 may include or be formed of a silicon oxide (SiOₓ)-based inorganic film, but an embodiment of the present disclosure is not limited thereto.

In another embodiment, the semiconductor substrate SSUB may be replaced with a glass substrate or a polymer resin substrate such as a polyimide substrate. In such an embodiment, thin film transistors may be disposed on the glass substrate or the polymer resin substrate. The glass substrate may be a rigid substrate that is not bent, and the polymer resin substrate may be a flexible substrate that may be bent or curved.

The light emitting element backplane EBP includes a plurality of conductive layers ML1 to ML8 and a plurality of vias VA1 to VA9. In addition, the light emitting element backplane EBP includes a plurality of insulating films INS1 to INS9 disposed between first to eighth conductive layers ML1 to ML8.

The first to eighth conductive layers ML1 to ML8 serve to implement circuits of subpixels by connecting the plurality of contact terminals CTE exposed from the semiconductor backplane SBP to each other.

A first insulating film INS1 may be disposed on the semiconductor backplane SBP. Each of first vias VA1 may penetrate the first insulating film INS1 to be connected to the contact terminal CTE exposed from the semiconductor backplane SBP. Each of the first conductive layers ML1 may be disposed on the first insulating film INS1 and connected to the first via VA1.

A second insulating film INS2 may be disposed on the first insulating film INS1 and the first conductive layers ML1. Each of second vias VA2 may penetrate the second insulating film INS2 to be connected to the exposed first conductive layer ML1. Each of the second conductive layers ML2 may be disposed on the second insulating film INS2 and connected to the second via VA2.

A third insulating film INS3 may be disposed on the second insulating film INS2 and the second conductive layers ML2. Each of third vias VA3 may penetrate the third insulating film INS3 to be connected to the exposed second conductive layer ML2. Each of the third conductive layers ML3 may be disposed on the third insulating film INS3 and connected to the third via VA3.

A fourth insulating film INS4 may be disposed on the third insulating film INS3 and the third conductive layers ML3. Each of fourth vias VA4 may penetrate the fourth insulating film INS4 to be connected to the exposed third conductive layer ML3. Each of the fourth conductive layers ML4 may be disposed on the fourth insulating film INS4 and connected to the fourth via VA4.

A fifth insulating film INS4 may be disposed on the fourth insulating film INS4 and the fourth conductive layers ML4. Each of fifth vias VA5 may penetrate the fifth insulating film INS5 to be connected to the exposed fourth conductive layer ML4. Each of the fifth conductive layers ML5 may be disposed on the fifth insulating film INS5 and connected to the fifth via VA5.

A sixth insulating film INS6 may be disposed on the fifth insulating film INS5 and the fifth conductive layers ML5. Each of sixth vias VA6 may penetrate the sixth insulating film INS6 to be connected to the exposed fifth conductive layer ML5. Each of the sixth conductive layers ML6 may be disposed on the sixth insulating film INS6 and connected to the sixth via VA6.

A seventh insulating film INS7 may be disposed on the sixth insulating film INS6 and the sixth conductive layers ML6. Each of seventh vias VA7 may penetrate the seventh insulating film INS7 to be connected to the exposed sixth conductive layer ML6. Each of the seventh conductive layers ML7 may be disposed on the seventh insulating film INS7 and connected to the seventh via VA7.

An eighth insulating film INS8 may be disposed on the seventh insulating film INS7 and the seventh conductive layers ML7. Each of eighth vias VA8 may penetrate the eighth insulating film INS8 to be connected to the exposed seventh conductive layer ML7. Each of the eighth conductive layers ML8 may be disposed on the eighth insulating film INS8 and connected to the eighth via VA8.

The first to eighth conductive layers ML1 to ML8 and the first to eighth vias VA1 to VA8 may include or be made of substantially a same material as each other. Each of the first to eighth conductive layers ML1 to ML8 and the first to eighth vias VA1 to VA8 may include or be made of at least one selected from copper (Cu), aluminum (Al), tungsten (W), molybdenum (Mo), chromium (Cr), gold (Au), titanium (Ti), nickel (Ni), and neodymium (Nd), or alloys thereof. The first to eighth vias VA1 to VA8 may include or be made of substantially a same material as each other. The first to eighth insulating films INS1 to INS8 may include or be formed of silicon oxide (SiOₓ)-based inorganic films, but an embodiment of the present disclosure is not limited thereto.

Each of a thickness of the first conductive layer ML1, a thickness of the second conductive layer ML2, a thickness of the third conductive layer ML3, a thickness of the fourth conductive layer ML4, a thickness of the fifth conductive layer ML5, and a thickness of the sixth conductive layer ML6 may be greater than each of a thickness of the first via VA1, a thickness of the second via VA2, a thickness of the third via VA3, a thickness of the fourth via VA4, a thickness of the fifth via VA5, and a thickness of the sixth via VA6. Each of the thickness of the second conductive layer ML2, the thickness of the third conductive layer ML3, the thickness of the fourth conductive layer ML4, the thickness of the fifth conductive layer ML5, and the thickness of the sixth conductive layer ML6 may be greater than the thickness of the first conductive layer ML1. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be substantially the same as each other. In an embodiment, for example, the thickness of the first conductive layer ML1 may be approximately 1,360 angstrom (Å), each of the thickness of the second conductive layer ML2, the thickness of the third conductive layer ML3, the thickness of the fourth conductive layer ML4, the thickness of the fifth conductive layer ML5, and the thickness of the sixth conductive layer ML6 may be approximately 1,440 Å, and each of the thickness of the first via VA1, the thickness of the second via VA2, the thickness of the third via VA3, the thickness of the fourth via VA4, the thickness of the fifth via VA5, and the thickness of the sixth via VA6 may be approximately 1,150 Å.

Each of a thickness of the seventh conductive layer ML7 and a thickness of the eighth conductive layer ML8 may be greater than each of the thickness of the first conductive layer ML1, the thickness of the second conductive layer ML2, the thickness of the third conductive layer ML3, the thickness of the fourth conductive layer ML4, the thickness of the fifth conductive layer ML5, and the thickness of the sixth conductive layer ML6. Each of the thickness of the seventh conductive layer ML7 and the thickness of the eighth conductive layer ML8 may be greater than each of a thickness of the seventh via VA7 and a thickness of the eighth via VA8. Each of the thickness of the seventh via VA7 and the thickness of the eighth via VA8 may be greater than each of the thickness of the first via VA1, the thickness of the second via VA2, the thickness of the third via VA3, the thickness of the fourth via VA4, the thickness of the fifth via VA5, and the thickness of the sixth via VA6. The thickness of the seventh conductive layer ML7 and the thickness of the eighth conductive layer ML8 may be substantially the same as each other. In an embodiment, for example, each of the thickness of the seventh conductive layer ML7 and the thickness of the eighth conductive layer ML8 may be approximately 9,000 Å. Each of the thickness of the seventh via VA7 and the thickness of the eighth via VA8 may be approximately 6,000 Å.

A ninth insulating film INS9 may be disposed on the eighth insulating film INS8 and the eighth conductive layer ML8. The ninth insulating film INS9 may include or be formed of a silicon oxide (SiOₓ)-based inorganic film, but an embodiment of the present disclosure is not limited thereto.

Each of ninth vias VA9 may penetrate the ninth insulating film INS9 to be connected to the exposed eighth conductive layer ML8. Each of the ninth vias VA9 may include or be made of at least one selected from copper (Cu), aluminum (Al), tungsten (W), molybdenum (Mo), chromium (Cr), gold (Au), titanium (Ti), nickel (Ni), and neodymium (Nd), or alloys thereof. A thickness of the ninth via VA9 may be approximately 16,500 Å.

The reflective electrode layer RL may be disposed on the ninth insulating film INS9. The reflective electrode layer RL may include one or more reflective electrodes RL1, RL2, RL3, and RL4, first step layers STPL1, and a second step layer STPL2. In an embodiment, for example, as illustrated in FIG. 2, one or more reflective electrodes RL1, RL2, RL3, and RL4 include first to fourth reflective electrodes RL1, RL2, RL3, and RL4, but an embodiment of the present disclosure is not limited thereto.

Each of the first reflective electrodes RL1 may be disposed on the ninth insulating film INS9 and connected to the ninth via VA9. Each of the first reflective electrodes RL1 may include or be made of at least one selected from copper (Cu), aluminum (Al), tungsten (W), molybdenum (Mo), chromium (Cr), gold (Au), titanium (Ti), nickel (Ni), and neodymium (Nd), or alloys thereof. In an embodiment, for example, each of the first reflective electrodes RL1 may include titanium nitride (TiN).

Each of the second reflective electrodes RL2 may be disposed on the first reflective electrode RL1. Each of the second reflective electrodes RL2 may include or be made of at least one selected from copper (Cu), aluminum (Al), tungsten (W), molybdenum (Mo), chromium (Cr), gold (Au), titanium (Ti), nickel (Ni), and neodymium (Nd), or alloys thereof. In an embodiment, for example, each of the second reflective electrodes RL2 may include aluminum (Al).

The first step layer STPL1 may be disposed on the second reflective electrode RL2. The second step layer STPL2 may be disposed on the first step layer STPL1.

The first step layer STPL1 and the second step layer STPL2 may include or be formed of silicon carbonitride (SiCN) or silicon oxide (SiOₓ)-based inorganic films, but an embodiment of the present disclosure is not limited thereto.

The third reflective electrode RL3 may be disposed on the second reflective electrode RL2. In addition, when the first step layer STPL1 is disposed on the second reflective electrode RL2, the third reflective electrode RL3 may be disposed on the first step layer STPL1. Further, when the first step layer STPL1 and the second step layer STPL2 are sequentially disposed on the second reflective electrode RL2, the third reflective electrode RL3 may be disposed on the second step layer STPL2. Each of the third reflective electrodes RL3 may include or be made of at least one selected from copper (Cu), aluminum (Al), tungsten (W), molybdenum (Mo), chromium (Cr), gold (Au), titanium (Ti), nickel (Ni), and neodymium (Nd), or alloys thereof. In an embodiment, for example, each of the third reflective electrodes RL3 may include titanium nitride (TiN).

In another embodiment, at least one selected from the first reflective electrode RL1, the second reflective electrode RL2, and the third reflective electrode RL3 may be omitted.

Each of the fourth reflective electrodes RL4 may be disposed on the third reflective electrode RL3. Each of the fourth reflective electrodes RL4 may include a metal having high reflectivity so as to be advantageous in reflecting light. In addition, a thickness of the fourth reflective electrode RL4 may be greater than a thickness of the first reflective electrode RL1, a thickness of the second reflective electrode RL2, and a thickness of the third reflective electrode RL3. Each of the fourth reflective electrodes RL4 may include or be made of at least one selected from copper (Cu), aluminum (Al), tungsten (W), molybdenum (Mo), chromium (Cr), gold (Au), titanium (Ti), nickel (Ni), and neodymium (Nd), or alloys thereof. In an embodiment, for example, each of the fourth reflective electrodes RL4 may include aluminum (Al) or titanium (Ti).

A tenth insulating film INS10 may be disposed on the ninth insulating film INS9 and the fourth reflective electrodes RL4. The tenth insulating film INS 10 may include or be formed of a silicon oxide (SiOₓ)-based inorganic film, but an embodiment of the present disclosure is not limited thereto.

Each of tenth vias VA10 may penetrate the tenth insulating film INS 10 to be connected to the exposed fourth reflective electrode RL4. Each of the tenth vias VA10 may include or be made of at least one selected from copper (Cu), aluminum (Al), tungsten (W), molybdenum (Mo), chromium (Cr), gold (Au), titanium (Ti), nickel (Ni), and neodymium (Nd), or alloys thereof.

A first electrode AND of each of light emitting elements may be disposed on the tenth insulating film INS10 and connected to the tenth via VA10. The first electrode AND of each of the light emitting elements may be connected to the drain region DA or the source region SA of the pixel transistor through the tenth via VA10, the first to fourth reflective electrodes RL1 to RL4, the first to ninth vias VA1 to VA9, the first to eighth conductive layers ML1 to ML8, and the contact terminal CTE. The first electrode AND of each of the light emitting elements may include or be made of at least one selected from copper (Cu), aluminum (Al), tungsten (W), molybdenum (Mo), chromium (Cr), gold (Au), titanium (Ti), nickel (Ni), and neodymium (Nd), or alloys thereof. In an embodiment, for example, the first electrode AND of each of the light emitting elements may be made of titanium nitride (TiN).

The pixel defining film PDL may be disposed on a partial area of the first electrode AND of each of the light emitting elements. The pixel defining film PDL may cover an edge of the first electrode AND of each of the light emitting elements.

The pixel defining film PDL may include first to third pixel defining films PDL1, PDL2, and PDL3. The first pixel defining film PDL1 may be disposed on the edge of the first electrode AND of each of the light emitting elements, the second pixel defining film PDL2 may be disposed on the first pixel defining film PDL1, and the third pixel defining film PDL3 may be disposed on the second pixel defining film PDL2. The first pixel defining film PDL1, the second pixel defining film PDL2, and the third pixel defining film PDL3 may include or be formed of silicon oxide (SiOₓ)-based inorganic films, but an embodiment of the present disclosure is not limited thereto. Each of a thickness of the first pixel defining film PDL1, a thickness of the second pixel defining film PDL2, and a thickness of the third pixel defining film PDL3 may be approximately 500 Å.

The first pixel defining film PDL1, the second pixel defining film PDL2, and the third pixel defining film PDL3 may have a cross-sectional structure having a step with a staircase shape. In an embodiment, for example, a width of the first pixel defining film PDL1 may be greater than a width of the second pixel defining film PDL2 and a width of the third pixel defining film PDL3, and the width of the second pixel defining film PDL2 may be greater than the width of the third pixel defining film PDL3.

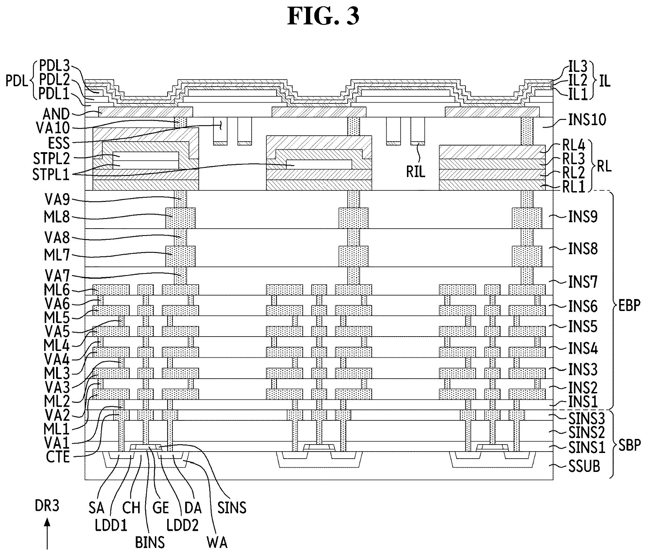

FIG. 3 is a cross-sectional view illustrating a state in which the deposition material is deposited in FIG. 2.

Referring to FIG. 3, in an embodiment, the deposition material may be deposited on the deposition substrate SUB. In some embodiments, the deposition material may be deposited on the pixel defining film PDL and the first electrode AND. The deposition material deposited on the deposition substrate SUB may constitute a light emitting stack IL.

The light emitting stack IL may include a plurality of intermediate layers. It has been illustrated in FIG. 3 that the light emitting stack IL has a three-tandem structure including a first stack layer IL1, a second stack layer IL2, and a third stack layer IL3, but an embodiment of the present disclosure is not limited thereto. In an embodiment, for example, the light emitting stack IL may have a two-tandem structure including two stack layers.

In the three-tandem structure, the light emitting stack IL may have a tandem structure including a plurality of stack layers IL1, IL2, and IL3 that emits different light. In an embodiment, for example, the light emitting stack IL may include a first stack layer IL1 that emits light of a first color, a second stack layer IL2 that emits light of a third color, and a third stack layer IL3 that emits light of a second color. The first stack layer IL1, the second stack layer IL2, and the third stack layer IL3 may be sequentially stacked.

The first stack layer IL1 may have a structure in which a first hole transporting layer, a first organic light emitting layer that emits the light of the first color, and a first electron transporting layer are sequentially stacked. The second stack layer IL2 may have a structure in which a second hole transporting layer, a second organic light emitting layer emitting the light of the third color, and a second electron transporting layer are sequentially stacked. The third stack layer IL3 may have a structure in which a third hole transporting layer, a third organic light emitting layer that emits the light of the second color, and a third electron transporting layer are sequentially stacked.

A first charge generation layer for supplying charges to the second stack layer IL2 and supplying electrons to the first stack layer IL1 may be disposed between the first stack layer IL1 and the second stack layer IL2. The first charge generation layer may include an n-type charge generation layer that supplies electrons to the first stack layer IL1 and a p-type charge generation layer that supplies holes to the second stack layer IL2. The n-type charge generation layer may include a dopant of a metal material.

A second charge generation layer for supplying charges to the third stack layer IL3 and supplying electrons to the second stack layer IL2 may be disposed between the second stack layer IL2 and the third stack layer IL3. The second charge generation layer may include an n-type charge generation layer that supplies electrons to the second stack layer IL2 and a p-type charge generation layer that supplies holes to the third stack layer IL3.

The first stack layer IL1 may be disposed on the first electrodes AND and the pixel defining film PDL, the second stack layer IL2 may be disposed on the first stack layer IL1, and the third stack layer IL3 may be disposed on the second stack layer IL2.

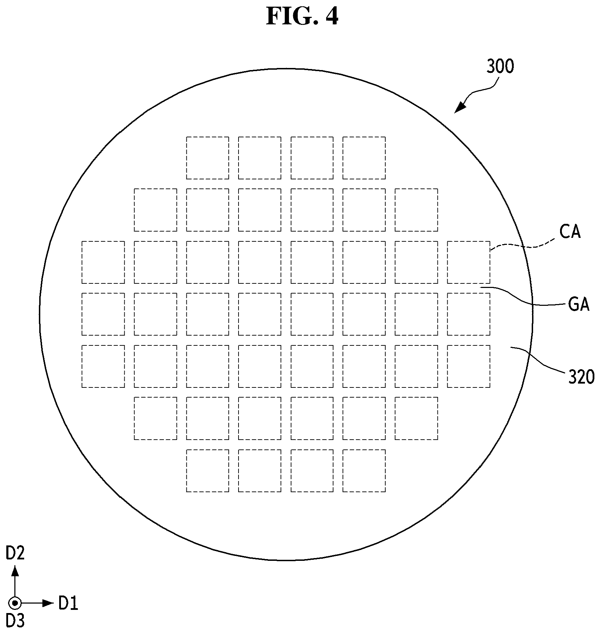

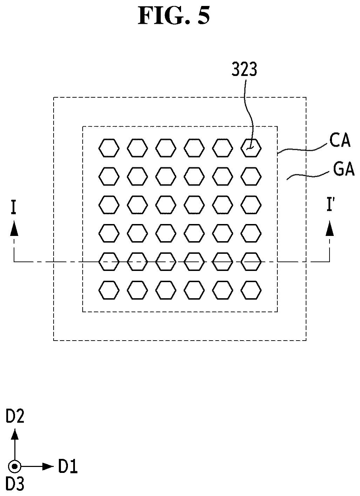

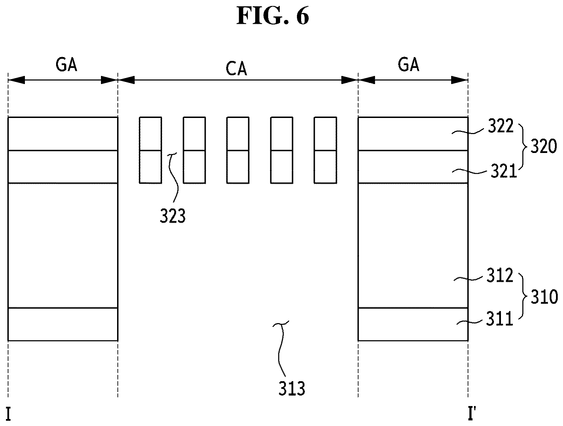

FIG. 4 is a schematic plan view for describing a mask assembly of FIG. 1. FIG. 5 is a schematic plan view for describing cell regions and a grid region illustrated in FIG. 4. FIG. 6 is a schematic cross-sectional view taken along line I-I' of FIG. 5.

Referring to FIGS. 4 to 6, in an embodiment, the mask assembly 300 may include a mask frame 310 and a membrane 320 disposed on the mask frame 310. In an embodiment, for example, the mask frame 310 may include an inorganic layer 311 and a base layer 312 disposed on the inorganic layer 311. In addition, the membrane 320 may include an insulating layer 321 disposed on the base layer 312 and an inorganic layer 322 disposed on the insulating layer 321. In an embodiment, the mask assembly 300 may be a fine silicon mask (FSM).

The membrane 320 may include one or more cell regions CA. In an embodiment, for example, the membrane 320 may include a plurality of cell regions CA arranged in a matrix form along a first direction D1 and a second direction D2 and a grid region GA disposed between the cell regions CA.

The mask frame 310 may have a plurality of cell openings 313 exposing the cell regions CA of the membrane 320. The cell regions CA of the membrane 320 may be disposed on the cell openings 313 of the mask frame 310, respectively.

Each of the cell regions CA of the membrane 320 may have a plurality of pixel openings 323. The plurality of pixel openings 323 may be formed or defined to penetrate each of the cell regions CA. In some embodiments, the pixel openings 323 of the membrane 320 may be connected to the cell openings CA of the mask frame 310, and the cell openings 313 of the mask frame 310 and the pixel openings 323 of the membrane 320 may function as paths for providing light emitting materials onto anode electrodes of the deposition substrate SUB in a deposition process for forming light emitting layers.

Referring back to FIG. 1, the mask stage 400 may be disposed below the mask assembly 300 to support the mask assembly 300. A stage opening may be formed or defined at the center of the mask stage 400. The stage opening formed at the center of the mask stage 400 may overlap the cell openings 313 and the pixel openings 323 of the mask assembly 300.

Hereinafter, an evaporation source 500 according to an embodiment of the present disclosure will be described with reference to the drawings.

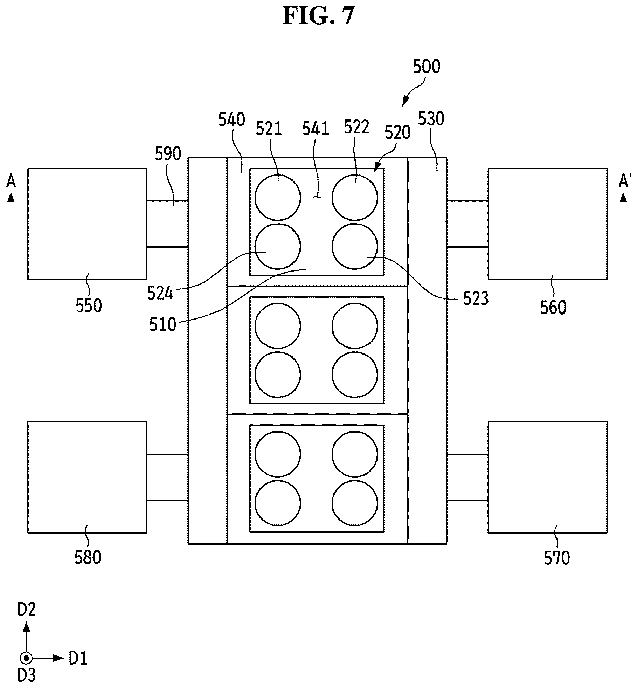

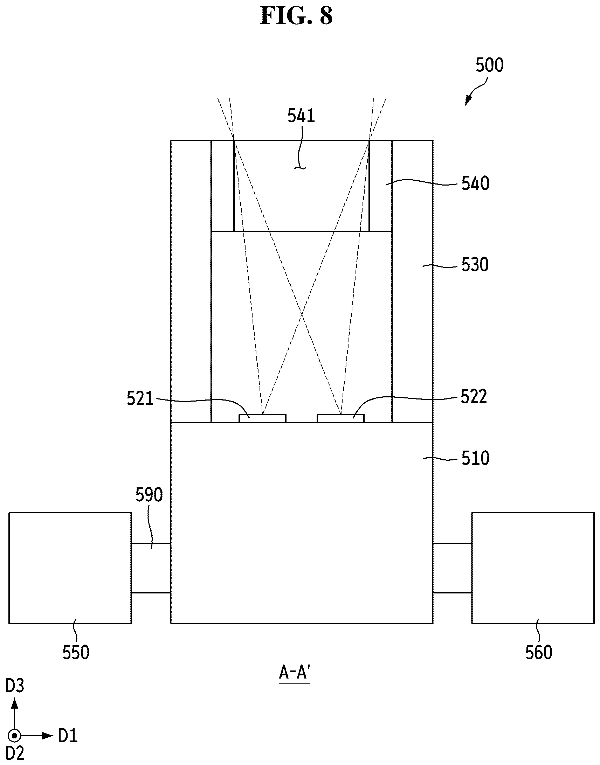

FIG. 7 is a plan view of an evaporation source according to an embodiment of the present disclosure. FIG. 8 is a cross-sectional view taken along line A-A' of FIG. 7.

Referring to FIGS. 7 and 8, an evaporation source 500 according to an embodiment of the present disclosure includes a main body 510, a deposition nozzle assembly 520, a support plate 530, an angle limiting portion 540, a plurality of vaporizing portions (e.g., first to fourth vaporizing portions 550 to 570), and a plurality of connecting portions 590.

The main body 510 may be disposed on a lower surface of the inner portion of the chamber 100. The main body 510 may be provided as a structure of a quadrangular box shape having a predetermined thickness. In an embodiment, for example, the main body 510 may be provided as a structure of a quadrangular box shape that has a rectangular shape, in a plan view (or when viewed in the third direction D3), having a pair of short sides in the first direction D 1 and a pair of long sides in the second direction D2 and has a thickness in the third direction D3. The main body 510 may have a lower surface in contact with the lower surface of the inner portion of the chamber 100 and an upper surface disposed above the lower surface of the inner portion of the chamber 100. The deposition nozzle assembly 520 may be disposed on the upper surface of the main body 510, and the main body 510 may support the deposition nozzle assembly 520.

The deposition nozzle assembly 520 is disposed above the main body 510, and configured to discharge a plurality of deposition materials. The number of deposition nozzle assemblies 520 may be plural, and the plurality of deposition nozzle assemblies 520 may be arranged along the second direction D2 above the main body 510. The deposition nozzle assembly 520 may include a first deposition nozzle 521, a second deposition nozzle 522, a third deposition nozzle 523, and a fourth deposition nozzle 524.

The first deposition nozzle 521 may be disposed above the main body 510, and may be connected to a first vaporizing portion 550 to be described later among the plurality of vaporizing portions. The first deposition nozzle 521 may discharge a first deposition material accommodated in the first vaporizing portion 550 in the third direction D3, which is an upward direction of the main body 510. The first deposition nozzle 521 may be connected to the first vaporizing portion 550 by the connecting portion 590, and may discharge the first deposition material vaporized inside the first vaporizing portion 550 in the third direction D3.

The second deposition nozzle 522 may be disposed above the main body 510, and may be spaced apart from the first deposition nozzle 521 in the first direction D1. The second deposition nozzle 522 may be connected to a second vaporizing portion 560 to be described later among the plurality of vaporizing portions. The second deposition nozzle 522 may discharge a second deposition material accommodated in the second vaporizing portion 560 in the third direction D3, which is the upward direction of the main body 510. The second deposition nozzle 522 may be connected to the second vaporizing portion 560 by the connecting portion 590, and may discharge the second deposition material vaporized inside the second vaporizing portion 560 in the third direction D3.

The third deposition nozzle 523 may be disposed above the main body 510, and may be spaced apart from the second deposition nozzle 522 in the second direction D2 crossing the first direction D1. The third deposition nozzle 523 may be connected to a third vaporizing portion 570 to be described later among the plurality of vaporizing portions. The third deposition nozzle 523 may discharge the first deposition material accommodated in the third vaporizing portion 570 in the third direction D3, which is the upward direction of the main body 510. The third deposition nozzle 523 may be connected to the third vaporizing portion 570 by the connecting portion 590, and may discharge the first deposition material vaporized inside the third vaporizing portion 570 in the third direction D3.

The fourth deposition nozzle 524 may be disposed above the main body 510, and may be spaced apart from the first deposition nozzle 521 in the second direction D2. The fourth deposition nozzle 524 may be connected to a fourth vaporizing portion 580 to be described later among the plurality of vaporizing portions. The fourth deposition nozzle 524 may discharge the second deposition material accommodated in the fourth vaporizing portion 580 in the third direction D3, which is the upward direction of the main body 510. The fourth deposition nozzle 524 may be connected to the fourth vaporizing portion 580 by the connecting portion 590, and may discharge the second deposition material vaporized inside the fourth vaporizing portion 580 in the third direction D3.

In an embodiment, as described above, the deposition nozzle assembly 520 may include four deposition nozzles, but the present disclosure is not limited thereto. The number of deposition nozzles included in the deposition nozzle assembly 520 may be changed or modified depending on the number of deposition materials, or the like.

An interval between the first deposition nozzle 521 and the fourth deposition nozzle 524 may be the same as an interval between the second deposition nozzle 522 and the third deposition nozzle 523. In some embodiments, a distance from the first deposition nozzle 521 to the fourth deposition nozzle 524 in the second direction D2 may be the same as a distance from the second deposition nozzle 522 to the third deposition nozzle 523 in the second direction D2.

In addition, an interval between the first deposition nozzle 521 and the second deposition nozzle 522 may be the same as an interval between the third deposition nozzle 523 and the fourth deposition nozzle 524. In some embodiments, a distance from the first deposition nozzle 521 to the second deposition nozzle 522 in the first direction D1 may be the same as a distance from the third deposition nozzle 523 to the fourth deposition nozzle 524 in the first direction D1.

The interval between the first deposition nozzle 521 and the fourth deposition nozzle 524 and the interval between the second deposition nozzle 522 and the third deposition nozzle 523 may be smaller than each of the interval between the first deposition nozzle 521 and the second deposition nozzle 522 and the interval between the third deposition nozzle 523 and the fourth deposition nozzle 524. In an embodiment, for example, the distance from the first deposition nozzle 521 to the fourth deposition nozzle 524 in the second direction D2 may be smaller than each of the distance from the first deposition nozzle 521 to the second deposition nozzle 522 in the first direction D1 and the distance from the third deposition nozzle 523 to the fourth deposition nozzle 524 in the first direction D1. In addition, the distance from the second deposition nozzle 522 to the third deposition nozzle 523 in the second direction D2 may be smaller than each of the distance from the first deposition nozzle 521 to the second deposition nozzle 522 in the first direction D1 and the distance from the third deposition nozzle 523 to the fourth deposition nozzle 524 in the first direction D1.

The support plate 530 may extend from the main body 510 in the upward direction. In some embodiments, the support plate 530 may extend from the upper surface of the main body 510 in the third direction D3. The number of support plates 530 may be plural, one of the plurality of support plates 530 may be disposed on one side (left side of FIG. 8) of the main body 510 in the first direction D1, and the other of the plurality of support plates 530 may be disposed on the other side (right side of FIG. 8) of the main body 510 in the first direction D1.

The angle limiting portion 540 is disposed above the deposition nozzle assembly 520, and configured to limit a discharge angle of the plurality of deposition materials discharged from the deposition nozzle assembly 520. The number of angle limiting portions 540 may be plural, and the plurality of angle limiting portions 540 may be arranged along the second direction D2 above each of the deposition nozzle assemblies 520. In some embodiments, each of the plurality of angle limiting portions 540 may be disposed above each of the plurality of deposition nozzle assemblies 520.

The angle limiting portion 540 may be supported by the support plate 530 to be located above the deposition nozzle assembly 520. In an embodiment, for example, the angle limiting portion 540 may be formed in a quadrangular box shape, and may be disposed between the support plate 530 located on one side (left side of FIG. 8) of the main body 510 in the first direction D1 and the support plate 530 located on the other side (right side of FIG. 8) of the main body 510 in the first direction D1. The angle limiting portion 540 may include an angle limiting hole 541.

The angle limiting hole 541 may be provided with a hole penetrating the angle limiting portion 540 in a thickness direction (i.e., the third direction D3) at a central portion of the angle limiting portion 540. In some embodiments, the angle limiting hole 541 may be an area where a portion of the central portion of the angle limiting portion 540 is removed. The angle limiting hole 541 may pass some of the plurality of deposition materials discharged from the deposition nozzle assembly 520 and limit the passage of the others of the plurality of deposition materials to limit the discharge angle of the deposition materials. In an embodiment, the angle limiting hole 541 may be a quadrangular hole when viewed from above the angle limiting portion 540 (or in a plan view), but is not limited thereto and may be provided as a circular hole, a polygonal hole, or the like.

The angle limiting hole 541 may overlap the first deposition nozzle 521, the second deposition nozzle 522, the third deposition nozzle 523, and the fourth deposition nozzle 524. In some embodiments, when the angle limiting portion 540 is viewed from above (or in a plan view), the first deposition nozzle 521, the second deposition nozzle 522, the third deposition nozzle 523, and the fourth deposition nozzle 524 may be disposed inside the angle limiting hole 541.

The plurality of vaporizing portions are configured to accommodate a plurality of deposition materials, vaporize the plurality of deposition materials, and supply the vaporized deposition materials to the deposition nozzle assembly 520. The plurality of vaporizing portions may include the first vaporizing portion 550, the second vaporizing portion 560, the third vaporizing portion 570, and the fourth vaporizing portion 580. The plurality of deposition materials may include the first deposition material and the second deposition material.

The first vaporizing portion 550 may accommodate the first deposition material. In some embodiments, the first vaporizing portion 550 may include an accommodation space for accommodating the first deposition material, and the first deposition material may be accommodated in the accommodation space. A plurality of partition walls (not illustrated) may be disposed inside the first vaporizing portion 550 so that the first deposition material is not accommodated in a state in which it is biased toward one direction. A separate heater (not illustrated) for vaporizing the first deposition material may be disposed inside the first vaporizing portion 550.

The first vaporizing portion 550 may include or be made of a material having a low coefficient of thermal expansion at a high temperature. In an embodiment, for example, the first vaporizing portion 550 may include or be made of chromium (Cr), molybdenum (Mo), platinum (Pt), tungsten (W), titanium (Ti), or the like, but a material of the first vaporizing portion 550 is not limited as long as it is a material having a low coefficient of thermal expansion at a high temperature.

The first vaporizing portion 550 may be spaced apart from the main body 510, and may be connected to the first deposition nozzle 521 by the connecting portion 590. The first vaporizing portion 550 may vaporize the first deposition material accommodated inside the first vaporizing portion 550 and supply the vaporized first deposition material to the first deposition nozzle 521 through the connecting portion 590.

The first deposition material accommodated inside the first vaporizing portion 550 may be an organic material for an organic light emitting layer. The first deposition material may be an organic material for a hole injecting layer, a hole transporting layer, an electron transporting layer, or an electron injecting layer, but is not limited thereto, and various materials may be applied as the first deposition material.

The second vaporizing portion 560 may accommodate the second deposition material. In some embodiments, the second vaporizing portion 560 may include an accommodation space for accommodating the second deposition material, and the second deposition material may be accommodated in the accommodation space. A plurality of partition walls (not illustrated) may be disposed inside the second vaporizing portion 560 so that the second deposition material is not accommodated in a state in which it is biased toward one direction. A separate heater (not illustrated) for vaporizing the second deposition material may be disposed inside the second vaporizing portion 560.

The second vaporizing portion 560 may include or be made of a material having a low coefficient of thermal expansion at a high temperature. In an embodiment, for example, the second vaporizing portion 560 may include or be made of chromium (Cr), molybdenum (Mo), platinum (Pt), tungsten (W), titanium (Ti), or the like, but a material of the second vaporizing portion 560 is not limited as long as it is a material having a low coefficient of thermal expansion at a high temperature.

The second vaporizing portion 560 may be spaced apart from the main body 510, and may be connected to the second deposition nozzle 522 by the connecting portion 590. The second vaporizing portion 560 may vaporize the second deposition material accommodated inside the second vaporizing portion 560 and supply the vaporized second deposition material to the second deposition nozzle 522 through the connecting portion 590.

The second deposition material accommodated inside the second vaporizing portion 560 may be an organic material for an organic light emitting layer, and may be a deposition material different from the first deposition material. The second deposition material may be an organic material for a hole injecting layer, a hole transporting layer, an electron transporting layer, or an electron injecting layer, but is not limited thereto, and various materials may be applied as the second deposition material.

The third vaporizing portion 570 may accommodate the first deposition material. In some embodiments, the third vaporizing portion 570 may include an accommodation space for accommodating the first deposition material, and the first deposition material may be accommodated in the accommodation space. A plurality of partition walls (not illustrated) may be disposed inside the third vaporizing portion 570 so that the first deposition material is not accommodated in a state in which it is biased toward one direction. A separate heater (not illustrated) for vaporizing the first deposition material may be disposed inside the third vaporizing portion 570.

The third vaporizing portion 570 may include or be made of a material having a low coefficient of thermal expansion at a high temperature. In an embodiment, for example, the third vaporizing portion 570 may include or be made of chromium (Cr), molybdenum (Mo), platinum (Pt), tungsten (W), titanium (Ti), or the like, but a material of the third vaporizing portion 570 is not limited as long as it is a material having a low coefficient of thermal expansion at a high temperature.

The third vaporizing portion 570 may be spaced apart from the main body 510, and may be connected to the third deposition nozzle 523 by the connecting portion 590. The third vaporizing portion 570 may vaporize the first deposition material accommodated inside the third vaporizing portion 570 and supply the vaporized first deposition material to the third deposition nozzle 523 through the connecting portion 590.

The fourth vaporizing portion 580 may accommodate the second deposition material. In some embodiments, the fourth vaporizing portion 580 may include an accommodation space for accommodating the second deposition material, and the second deposition material may be accommodated in the accommodation space. A plurality of partition walls (not illustrated) may be disposed inside the fourth vaporizing portion 580 so that the second deposition material is not accommodated in a state in which it is biased toward one direction. A separate heater (not illustrated) for vaporizing the second deposition material may be disposed inside the fourth vaporizing portion 580.

The fourth vaporizing portion 580 may include or be made of a material having a low coefficient of thermal expansion at a high temperature. In an embodiment, for example, the fourth vaporizing portion 580 may include or be made of chromium (Cr), molybdenum (Mo), platinum (Pt), tungsten (W), titanium (Ti), or the like, but a material of the fourth vaporizing portion 580 is not limited as long as it is a material having a low coefficient of thermal expansion at a high temperature.

The fourth vaporizing portion 580 may be spaced apart from the main body 510, and may be connected to the fourth deposition nozzle 524 by the connecting portion 590. The fourth vaporizing portion 580 may vaporize the second deposition material accommodated inside the fourth vaporizing portion 580 and supply the vaporized second deposition material to the fourth deposition nozzle 524 through the connecting portion 590.

The connecting portions 590 may connect the plurality of vaporizing portions and the deposition nozzle assembly 520 to each other to provide passages for the plurality of deposition materials to move to the deposition nozzle assembly 520. The connecting portions 590 may connect the first deposition nozzle 521 and the first vaporizing portion 550 to each other, may connect the second deposition nozzle 522 and the second vaporizing portion 560 to each other, may connect the third deposition nozzle 523 and the third vaporizing portion 570 to each other, and may connect the fourth deposition nozzle 524 and the fourth vaporizing portion 580 to each other. The connecting portions 590 may be partially disposed inside the main body 510 in a process of connecting the plurality of vaporizing portions and the deposition nozzle assembly 520 to each other.

In an embodiment, as described above, the plurality of vaporizing portions accommodating the plurality of deposition materials are separated from the main body 510, and thus, an accommodation space for accommodating the deposition materials may not be formed inside the main body 510. Accordingly, a degree of freedom in disposing the deposition nozzles above the main body 510 may be increased. In some embodiments, an interval between the deposition nozzles may be minimized, and thus, mixing uniformity of the plurality of deposition materials may be increased.

In an embodiment, as described above, the plurality of vaporizing portions may include four vaporizing portions and the plurality of deposition materials include two deposition materials, but the present disclosure is not limited thereto. The number of vaporizing portions and the number of deposition materials may be changed or modified as desired.

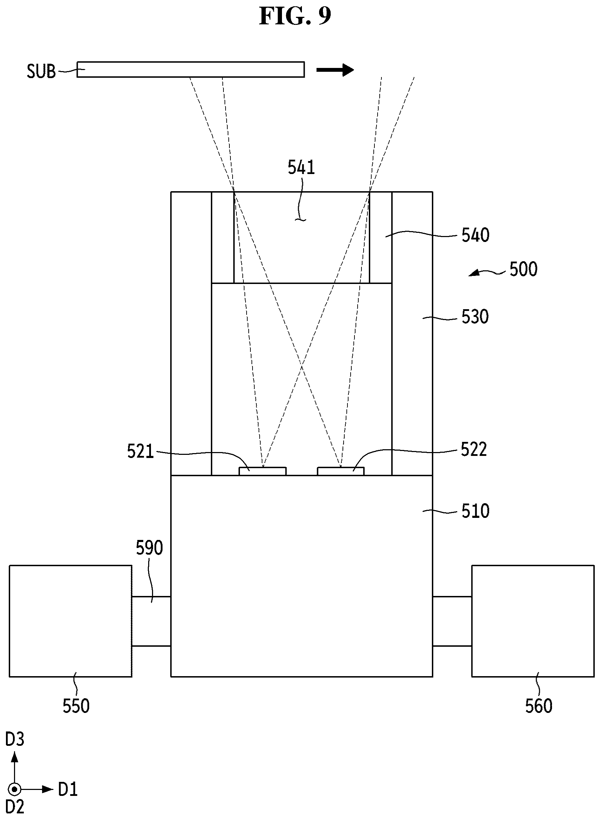

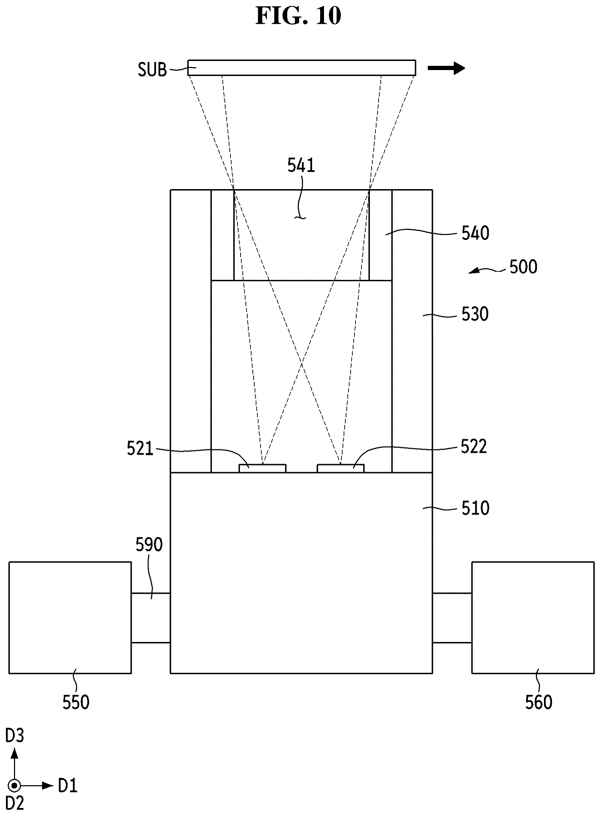

FIGS. 9 and 10 are views illustrating a state of depositing deposition materials on the deposition substrate using the evaporation source according to an embodiment of the present disclosure.

Referring to FIGS. 9 and 10, when the deposition materials are being discharged from the deposition nozzle assembly 520 of the evaporation source 500, the deposition substrate SUB may move in the first direction D1 above the evaporation source 500, and as the deposition substrate SUB moves, the deposition materials may be deposited on a lower portion of the deposition substrate SUB. In an embodiment, for example, the first deposition material may be discharged through the first deposition nozzle 521 and the third deposition nozzle 523, and the second deposition material may be discharged through the second deposition nozzle 522 and the fourth deposition nozzle 524. The first deposition material and the second deposition material discharged through the deposition nozzle assembly 520 may be mixed with each other, and the mixed first deposition material and second deposition material may be deposited on the lower portion of the deposition substrate SUB to form a deposition layer.

Hereinafter, an evaporation source 500 according to another embodiment of the present disclosure will be described with reference to the drawings.

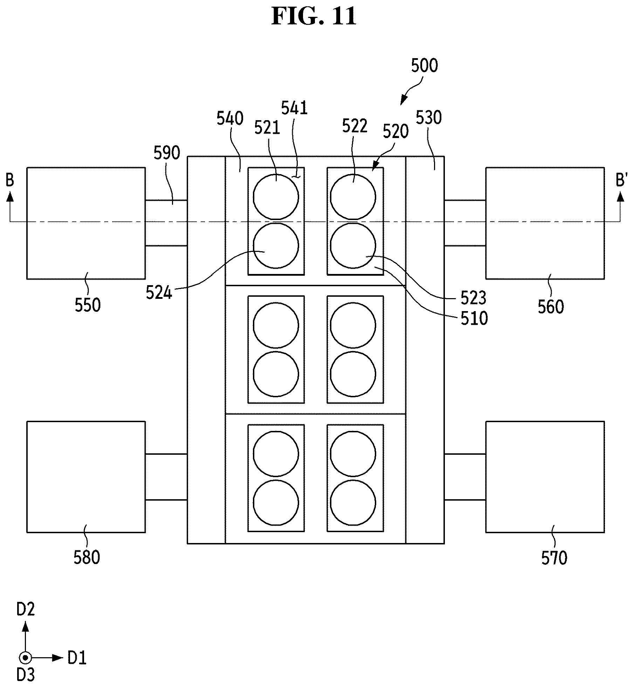

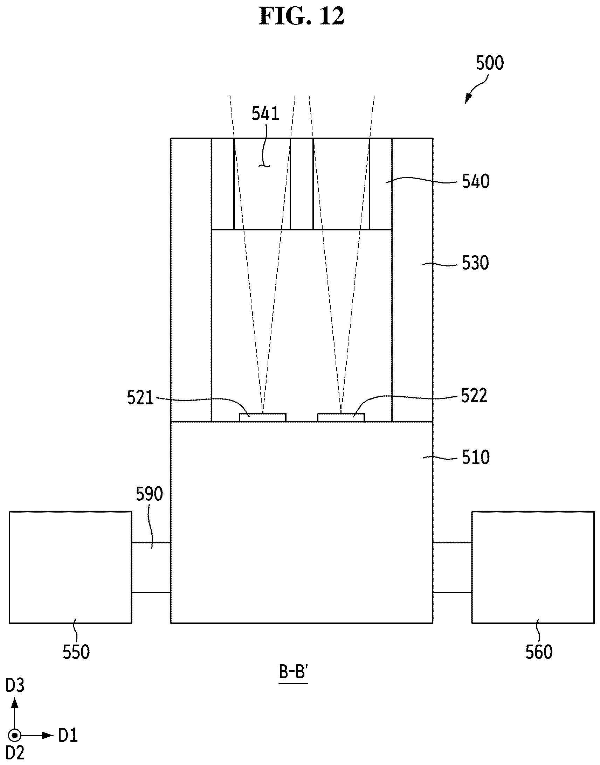

FIG. 11 is a plan view of an evaporation source according to another embodiment of the present disclosure. FIG. 12 is a cross-sectional view taken along line B-B' of FIG. 11.

Referring to FIGS. 11 and 12, an evaporation source 500 according to another embodiment of the present disclosure may include a main body 510, a deposition nozzle assembly 520, a support plate 530, an angle limiting portion 540, a plurality of vaporizing portions, and a plurality of connecting portions 590.

The main body 510 may be disposed on a lower surface of the inner portion of the chamber 100. The main body 510 may be provided as a structure of a quadrangular box shape having a selected thickness. In an embodiment, for example, the main body 510 may be provided as a structure of a quadrangular box shape that has a rectangular shape, in a plan view (or when viewed in the third direction D3), having a pair of short sides in the first direction D1 and a pair of long sides in the second direction D2 and has a thickness in the third direction D3. The main body 510 may have a lower surface in contact with the lower surface of the inner portion of the chamber 100 and an upper surface disposed above the lower surface of the inner portion of the chamber 100. The deposition nozzle assembly 520 may be disposed on the upper surface of the main body 510, and the main body 510 may support the deposition nozzle assembly 520.

The deposition nozzle assembly 520 may be disposed above the main body 510, and may discharge a plurality of deposition materials. The number of deposition nozzle assemblies 520 may be plural, and the plurality of deposition nozzle assemblies 520 may be arranged along the second direction D2 above the main body 510. The deposition nozzle assembly 520 may include a first deposition nozzle 521, a second deposition nozzle 522, a third deposition nozzle 523, and a fourth deposition nozzle 524.

The first deposition nozzle 521 may be disposed above the main body 510, and may be connected to a first vaporizing portion 550 of the plurality of vaporizing portions. The first deposition nozzle 521 may discharge a first deposition material accommodated in the first vaporizing portion 550 in the third direction D3, which is the upward direction of the main body 510. The first deposition nozzle 521 may be connected to the first vaporizing portion 550 by the connecting portion 590, and may discharge the first deposition material vaporized inside the first vaporizing portion 550 in the third direction D3.

The second deposition nozzle 522 may be disposed above the main body 510, and may be spaced apart from the first deposition nozzle 521 in the first direction D1. The second deposition nozzle 522 may be connected to a second vaporizing portion 560 of the plurality of vaporizing portions. The second deposition nozzle 522 may discharge a second deposition material accommodated in the second vaporizing portion 560 in the third direction D3, which is the upward direction of the main body 510. The second deposition nozzle 522 may be connected to the second vaporizing portion 560 by the connecting portion 590, and may discharge the second deposition material vaporized inside the second vaporizing portion 560 in the third direction D3.

The third deposition nozzle 523 may be disposed above the main body 510, and may be spaced apart from the second deposition nozzle 522 in the second direction D2 crossing the first direction D1. The third deposition nozzle 523 may be connected to a third vaporizing portion 570 of the plurality of vaporizing portions. The third deposition nozzle 523 may discharge a third deposition material accommodated in the third vaporizing portion 570 in the third direction D3, which is the upward direction of the main body 510. The third deposition nozzle 523 may be connected to the third vaporizing portion 570 by the connecting portion 590, and may discharge the third deposition material vaporized inside the third vaporizing portion 570 in the third direction D3.

The fourth deposition nozzle 524 may be disposed above the main body 510, and may be spaced apart from the first deposition nozzle 521 in the second direction D2. The fourth deposition nozzle 524 may be connected to a fourth vaporizing portion 580 of the plurality of vaporizing portions. The fourth deposition nozzle 524 may discharge a fourth deposition material accommodated in the fourth vaporizing portion 580 in the third direction D3, which is the upward direction of the main body 510. The fourth deposition nozzle 524 may be connected to the fourth vaporizing portion 580 by the connecting portion 590, and may discharge the fourth deposition material vaporized inside the fourth vaporizing portion 580 in the third direction D3.

In an embodiment, as described above, the deposition nozzle assembly 520 may include four deposition nozzles, but the present disclosure is not limited thereto. The number of deposition nozzles included in the deposition nozzle assembly 520 may be changed or modified depending on the number of deposition materials, or the like.

An interval between the first deposition nozzle 521 and the fourth deposition nozzle 524 may be the same as an interval between the second deposition nozzle 522 and the third deposition nozzle 523. In some embodiments, a distance from the first deposition nozzle 521 to the fourth deposition nozzle 524 in the second direction D2 may be the same as a distance from the second deposition nozzle 522 to the third deposition nozzle 523 in the second direction D2.

In addition, an interval between the first deposition nozzle 521 and the second deposition nozzle 522 may be the same as an interval between the third deposition nozzle 523 and the fourth deposition nozzle 524. In some embodiments, a distance from the first deposition nozzle 521 to the second deposition nozzle 522 in the first direction D1 may be the same as a distance from the third deposition nozzle 523 to the fourth deposition nozzle 524 in the first direction D1.

The interval between the first deposition nozzle 521 and the fourth deposition nozzle 524 and the interval between the second deposition nozzle 522 and the third deposition nozzle 523 may be smaller than each of the interval between the first deposition nozzle 521 and the second deposition nozzle 522 and the interval between the third deposition nozzle 523 and the fourth deposition nozzle 524. In an embodiment, for example, the distance from the first deposition nozzle 521 to the fourth deposition nozzle 524 in the second direction D2 may be smaller than each of the distance from the first deposition nozzle 521 to the second deposition nozzle 522 in the first direction D1 and the distance from the third deposition nozzle 523 to the fourth deposition nozzle 524 in the first direction D1. In addition, the distance from the second deposition nozzle 522 to the third deposition nozzle 523 in the second direction D2 may be smaller than each of the distance from the first deposition nozzle 521 to the second deposition nozzle 522 in the first direction D1 and the distance from the third deposition nozzle 523 to the fourth deposition nozzle 524 in the first direction D1.

The support plate 530 may extend from the main body 510 in the upward direction. In some embodiments, the support plate 530 may extend from the upper surface of the main body 510 in the third direction D3. The number of support plates 530 may be plural, one of the plurality of support plates 530 may be disposed on one side (left side of FIG. 12) of the main body 510 in the first direction D1, and another of the plurality of support plates 530 may be disposed on the other side (right side of FIG. 12) of the main body 510 in the first direction D1.

The angle limiting portion 540 may be disposed above the deposition nozzle assembly 520, and may limit a discharge angle of the plurality of deposition materials discharged from the deposition nozzle assembly 520. The number of angle limiting portions 540 may be plural, and the plurality of angle limiting portions 540 may be arranged along the second direction D2 above each of the deposition nozzle assemblies 520. In some embodiments, each of the plurality of angle limiting portions 540 may be disposed above each of the plurality of deposition nozzle assemblies 520.

The angle limiting portion 540 may be supported by the support plate 530 so as to be located above the deposition nozzle assembly 520. In an embodiment, for example, the angle limiting portion 540 may be formed in a quadrangular box shape, and may be disposed between the support plate 530 located on one side (left side of FIG. 12) of the main body 510 in the first direction D1 and the support plate 530 located on the other side (right side of FIG. 12) of the main body 510 in the first direction D1. The angle limiting portion 540 may include an angle limiting hole 541.

The angle limiting hole 541 may be provided as a hole penetrating the angle limiting portion 540 in the thickness direction (i.e., the third direction D3). In some embodiments, the angle limiting hole 541 may be an area where a portion of the angle limiting portion 540 is removed. The angle limiting hole 541 may pass some of the plurality of deposition materials discharged from the deposition nozzle assembly 520 and limit the passage of the others of the plurality of deposition materials to limit the discharge angle of the deposition materials. In an embodiment, the angle limiting hole 541 may be a quadrangular hole when viewed from above the angle limiting portion 540 (or in a plan view), but is not limited thereto and may be provided as a circular hole, a polygonal hole, or the like.

The number of angle limiting holes 541 may be plural. One angle limiting hole 541 of the plurality of angle limiting holes 541 may overlap the first deposition nozzle 521 and the fourth deposition nozzle 524, and the other angle limiting hole 541 of the plurality of angle limiting holes 541 may overlap the second deposition nozzle 522 and the third deposition nozzle 523. In some embodiments, when the angle limiting portion 540 is viewed from above (or in a plan view), the first deposition nozzle 521 and the fourth deposition nozzle 524 may be disposed inside one angle limiting hole 541, and the second deposition nozzle 522 and the third deposition nozzle 523 may be disposed inside the other angle limiting hole 541.

The plurality of vaporizing portions may accommodate a plurality of deposition materials, vaporize the plurality of deposition materials, and supply the vaporized deposition materials to the deposition nozzle assembly 520. The plurality of vaporizing portions may include the first vaporizing portion 550, the second vaporizing portion 560, the third vaporizing portion 570, and the fourth vaporizing portion 580. The plurality of deposition materials may include the first deposition material, the second deposition material, the third deposition material, and the fourth deposition material.

The first vaporizing portion 550 may accommodate the first deposition material. In some embodiments, the first vaporizing portion 550 may include an accommodation space for accommodating the first deposition material, and the first deposition material may be accommodated in the accommodation space. A plurality of partition walls (not illustrated) may be disposed inside the first vaporizing portion 550 so that the first deposition material is not accommodated in a state in which it is biased toward one direction. A separate heater (not illustrated) for vaporizing the first deposition material may be disposed inside the first vaporizing portion 550.

The first vaporizing portion 550 may include or be made of a material having a low coefficient of thermal expansion at a high temperature. In an embodiment, for example, the first vaporizing portion 550 may include or be made of chromium (Cr), molybdenum (Mo), platinum (Pt), tungsten (W), titanium (Ti), or the like, but a material of the first vaporizing portion 550 is not limited as long as it is a material having a low coefficient of thermal expansion at a high temperature.

The first vaporizing portion 550 may be spaced apart from the main body 510, and may be connected to the first deposition nozzle 521 by the connecting portion 590. The first vaporizing portion 550 may vaporize the first deposition material accommodated inside the first vaporizing portion 550 and supply the vaporized first deposition material to the first deposition nozzle 521 through the connecting portion 590.

The first deposition material accommodated inside the first vaporizing portion 550 may be an organic material for an organic light emitting layer. The first deposition material may be an organic material for a hole injecting layer, a hole transporting layer, an electron transporting layer, or an electron injecting layer, but is not limited thereto, and various materials may be applied as the first deposition material.

The second vaporizing portion 560 may accommodate the second deposition material. In some embodiments, the second vaporizing portion 560 may include an accommodation space for accommodating the second deposition material, and the second deposition material may be accommodated in the accommodation space. A plurality of partition walls (not illustrated) may be disposed inside the second vaporizing portion 560 so that the second deposition material is not accommodated in a state in which it is biased toward one direction. A separate heater (not illustrated) for vaporizing the second deposition material may be disposed inside the second vaporizing portion 560.

The second vaporizing portion 560 may include or be made of a material having a low coefficient of thermal expansion at a high temperature. In an embodiment, for example, the second vaporizing portion 560 may include or be made of chromium (Cr), molybdenum (Mo), platinum (Pt), tungsten (W), titanium (Ti), or the like, but a material of the second vaporizing portion 560 is not limited as long as it is a material having a low coefficient of thermal expansion at a high temperature.

The second vaporizing portion 560 may be spaced apart from the main body 510, and may be connected to the second deposition nozzle 522 by the connecting portion 590. The second vaporizing portion 560 may vaporize the second deposition material accommodated inside the second vaporizing portion 560 and supply the vaporized second deposition material to the second deposition nozzle 522 through the connecting portion 590.

The second deposition material accommodated inside the second vaporizing portion 560 may be an organic material for an organic light emitting layer, and may be a deposition material different from the first deposition material. The second deposition material may be an organic material for a hole injecting layer, a hole transporting layer, an electron transporting layer, or an electron injecting layer, but is not limited thereto, and various materials may be applied as the second deposition material.

The third vaporizing portion 570 may accommodate the third deposition material. In some embodiments, the third vaporizing portion 570 may include an accommodation space for accommodating the third deposition material, and the third deposition material may be accommodated in the accommodation space. A plurality of partition walls (not illustrated) may be disposed inside the third vaporizing portion 570 so that the third deposition material is not accommodated in a state in which it is biased toward one direction. A separate heater (not illustrated) for vaporizing the third deposition material may be disposed inside the third vaporizing portion 570.

The third vaporizing portion 570 may include or be made of a material having a low coefficient of thermal expansion at a high temperature. In an embodiment, for example, the third vaporizing portion 570 may include or be made of chromium (Cr), molybdenum (Mo), platinum (Pt), tungsten (W), titanium (Ti), or the like, but a material of the third vaporizing portion 570 is not limited as long as it is a material having a low coefficient of thermal expansion at a high temperature.

The third vaporizing portion 570 may be spaced apart from the main body 510, and may be connected to the third deposition nozzle 523 by the connecting portion 590. The third vaporizing portion 570 may vaporize the third deposition material accommodated inside the third vaporizing portion 570 and supply the vaporized third deposition material to the third deposition nozzle 523 through the connecting portion 590.

The third deposition material accommodated inside the third vaporizing portion 570 may be an organic material for an organic light emitting layer, and may be a deposition material different from the first deposition material and the second deposition material. The third deposition material may be an organic material for a hole injecting layer, a hole transporting layer, an electron transporting layer, or an electron injecting layer, but is not limited thereto, and various materials may be applied as the third deposition material.

The fourth vaporizing portion 580 may accommodate the fourth deposition material. In some embodiments, the fourth vaporizing portion 580 may include an accommodation space for accommodating the fourth deposition material, and the fourth deposition material may be accommodated in the accommodation space. A plurality of partition walls (not illustrated) may be disposed inside the fourth vaporizing portion 580 so that the fourth deposition material is not accommodated in a state in which it is biased toward one direction. A separate heater (not illustrated) for vaporizing the fourth deposition material may be disposed inside the fourth vaporizing portion 580.

The fourth vaporizing portion 580 may include or be made of a material having a low coefficient of thermal expansion at a high temperature. In an embodiment, for example, the fourth vaporizing portion 580 may include or be made of chromium (Cr), molybdenum (Mo), platinum (Pt), tungsten (W), titanium (Ti), or the like, but a material of the fourth vaporizing portion 580 is not limited as long as it is a material having a low coefficient of thermal expansion at a high temperature.

The fourth vaporizing portion 580 may be spaced apart from the main body 510, and may be connected to the fourth deposition nozzle 524 by the connecting portion 590. The fourth vaporizing portion 580 may vaporize the fourth deposition material accommodated inside the fourth vaporizing portion 580 and supply the vaporized fourth deposition material to the fourth deposition nozzle 524 through the connecting portion 590.

The fourth deposition material accommodated inside the fourth vaporizing portion 580 may be an organic material for an organic light emitting layer, and may be a deposition material different from the first deposition material, the second deposition material, and the third deposition material. The fourth deposition material may be an organic material for a hole injecting layer, a hole transporting layer, an electron transporting layer, or an electron injecting layer, but is not limited thereto, and various materials may be applied as the fourth deposition material.

The connecting portions 590 may connect the plurality of vaporizing portions and the deposition nozzle assembly 520 to each other to provide passages for the plurality of deposition materials to move to the deposition nozzle assembly 520. The connecting portions 590 may connect the first deposition nozzle 521 and the first vaporizing portion 550 to each other, may connect the second deposition nozzle 522 and the second vaporizing portion 560 to each other, may connect the third deposition nozzle 523 and the third vaporizing portion 570 to each other, and may connect the fourth deposition nozzle 524 and the fourth vaporizing portion 580 to each other. The connecting portions 590 may be partially disposed inside the main body 510 in a process of connecting the plurality of vaporizing portions and the deposition nozzle assembly 520 to each other.

In an embodiment, as described above, the plurality of vaporizing portions accommodating the plurality of deposition materials are separated from the main body 510, and thus, an accommodation space for accommodating the deposition materials may not be formed inside the main body 510. Accordingly, a degree of freedom in disposing the deposition nozzles above the main body 510 may be increased. In some embodiments, an interval between the deposition nozzles may be minimized, and thus, mixing uniformity of the plurality of deposition materials may be increased.

In an embodiment, as described above, the plurality of vaporizing portions may include four vaporizing portions and the plurality of deposition materials include four deposition materials, but the present disclosure is not limited thereto. The number of vaporizing portions and the number of deposition materials may be changed or modified as desired.

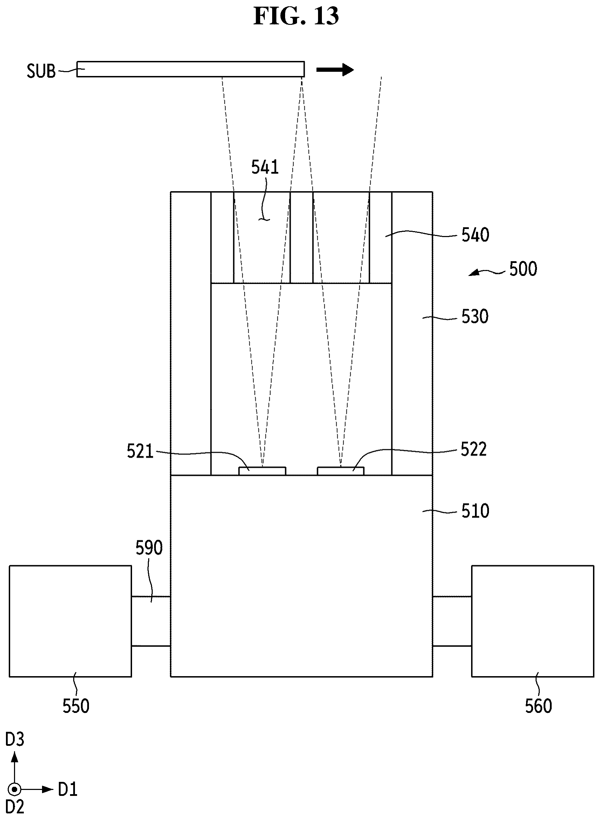

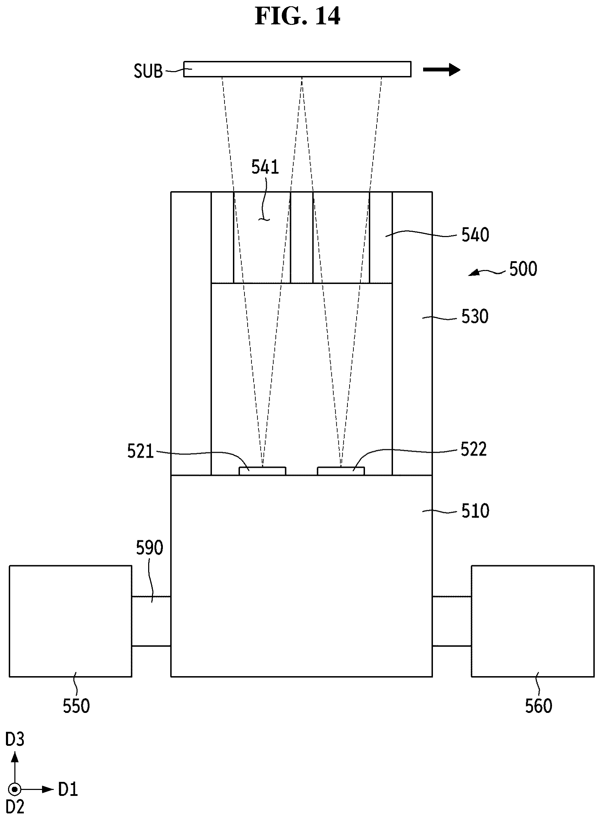

FIGS. 13 and 14 are views illustrating a state of depositing deposition materials on the deposition substrate using the evaporation source according to another embodiment of the present disclosure.

Referring to FIGS. 13 and 14, when the deposition materials are being discharged from the deposition nozzle assembly 520 of the evaporation source 500, the deposition substrate SUB may move in the first direction D1 above the evaporation source 500, and as the deposition substrate SUB moves, the deposition materials may be deposited on a lower portion of the deposition substrate SUB. In an embodiment, for example, the first deposition material may be discharged through the first deposition nozzle 521, the second deposition material may be discharged through the second deposition nozzle 522, the third deposition material may be discharged through the third deposition nozzle 523, and the fourth deposition material may be discharged through the fourth deposition nozzle 524.

The first deposition material and the fourth deposition material respectively discharged through the first deposition nozzle 521 and the fourth deposition nozzle 524 may be mixed with each other and deposited on the lower portion of the deposition substrate SUB through one angle limiting hole 541. Since the deposition substrate SUB moves from the left side to the right side in FIGS. 13 and 14, the mixed first deposition material and fourth deposition material may be deposited on the lower portion of the deposition substrate SUB to form a first deposition layer.

In addition, the second deposition material and the third deposition material respectively discharged through the second deposition nozzle 522 and the third deposition nozzle 523 may be mixed with each other and deposited on the lower portion of the deposition substrate SUB through the other angle limiting hole 541. Since the deposition substrate SUB moves from the left side to the right side in FIGS. 13 and 14, the mixed second deposition material and third deposition material may be deposited on a lower portion of the first deposition layer to form a second deposition layer.

A display device manufactured using the deposition apparatus 10 according to an embodiment of the present disclosure may be applied to various electronic devices. An electronic device according to an embodiment includes the display device described above, and may further include modules or devices having additional functions in addition to the display device.

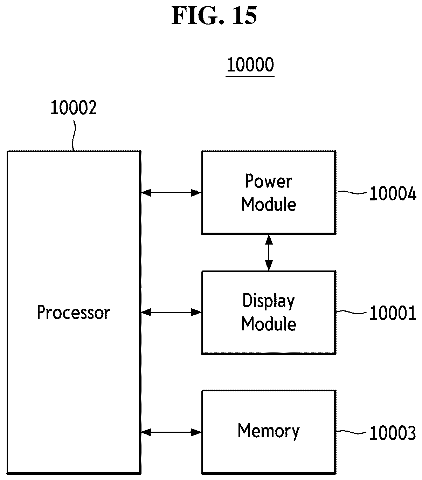

FIG. 15 is a block diagram of an electronic device according to an embodiment.

Referring to FIG. 15, an electronic device 10000 according to an embodiment may include a display module 10001, a processor 10002, a memory 10003, and a power module 10004.

The processor 10002 may include at least one selected from a central processing unit (CPU), an application processor (AP), a graphic processing unit (GPU), a communication processor (CP), an image signal processor (ISP), and a controller.

The memory 10003 may store data information used for an operation of the processor 10002 or the display module 10001. When the processor 10002 executes an application stored in the memory 10003, an image data signal and/or an input control signal may be transferred to the display module 10001, and the display module 10001 may process the received signal and output image information through a display screen.

The power module 10004 may include a power supply module such as a power adapter or a battery device and a power conversion module converting power supplied by the power supply module to generate power used for an operation of the electronic device 10000.

At least one of the respective components of the above-described electronic device 10000 may be included in the display device according to the above-described embodiments. In addition, some of individual modules functionally included in one module may be included in the display device, and the others of the individual modules may be provided separately from the display device. In an embodiment, for example, the display device may include the display module 10001, and the processor 10002, the memory 10003, and the power module 10004 may be provided in the form of other devices within the electronic device 10000 rather than the display device.

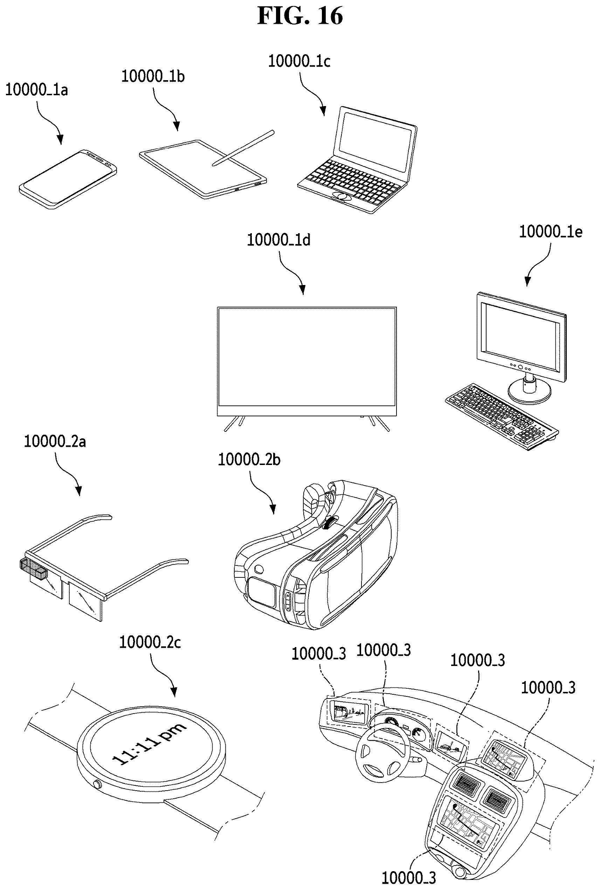

FIG. 16 is schematic views of electronic devices according to various embodiments.

Referring to FIG. 16, various electronic devices to which the display device according to embodiments is applied may include not only image display electronic devices such as a smartphone 10000_1a, a tablet personal computer (PC) 10000_1b, a laptop computer 10000_1c, a television (TV) 10000_1d, and a monitor 10000_1e for a desktop computer, but also wearable electronic devices including display modules, such as a smart glasses 10000_2a, a head mounted display 10000_2b, and a smart watch 10000_2c, and vehicle electronic devices 1_3 including display modules, such as a center information display (CID) disposed on an instrument board, a center fascia, or a dashboard of a vehicle and a room mirror display.

## Claims

1. An evaporation source (500) comprising:
a main body (510);
a deposition nozzle assembly (520) disposed above the main body (510), wherein the deposition nozzle assembly (520) is configured to discharge a plurality of deposition materials;
an angle limiting portion (540) disposed above the deposition nozzle assembly (520), wherein the angle limiting portion (540) is configured to limit a discharge angle of the plurality of deposition materials discharged from the deposition nozzle assembly (520); and
a plurality of vaporizing portions (550) configured to accommodate the plurality of deposition materials, vaporize the plurality of deposition materials, and supply the vaporized deposition materials to the deposition nozzle assembly (520).

2. The evaporation source (500) of claim 1, wherein the deposition nozzle assembly (520) includes:
a first deposition nozzle (521);
a second deposition nozzle (522) spaced apart from the first deposition nozzle (521) in a first direction;
a third deposition nozzle (523) spaced apart from the second deposition nozzle (522) in a second direction crossing the first direction; and
a fourth deposition nozzle (524) spaced apart from the first deposition nozzle (521) in the second direction.

3. The evaporation source (500) of claim 2, wherein an interval between the first deposition nozzle (521) and the fourth deposition nozzle (524) is the same as an interval between the second deposition nozzle (522) and the third deposition nozzle (523), and
an interval between the first deposition nozzle (521) and the second deposition nozzle (522) is the same as an interval between the third deposition nozzle (523) and the fourth deposition nozzle (524).

4. The evaporation source (500) of claim 2, wherein each of an interval between the first deposition nozzle (521) and the fourth deposition nozzle (524) and an interval between the second deposition nozzle (522) and the third deposition nozzle (523) are smaller than each of an interval between the first deposition nozzle (521) and the second deposition nozzle (522) and an interval between the third deposition nozzle (523) and the fourth deposition nozzle (524).

5. The evaporation source (500) of claim 2, wherein the plurality of vaporizing portions (550) includes a first vaporizing portion (550), a second vaporizing portion (560), a third vaporizing portion (570), and a fourth vaporizing portion (580),
the first vaporizing portion (550) is connected to the first deposition nozzle (521),
the second vaporizing portion (560) is connected to the second deposition nozzle (522),
the third vaporizing portion (570) is connected to the third deposition nozzle (523), and
the fourth vaporizing portion (580) is connected to the fourth deposition nozzle (524).

6. The evaporation source (500) of claim 5, wherein the plurality of deposition materials includes a first deposition material and a second deposition material,
the first deposition material is accommodated in the first vaporizing portion (550) and the third vaporizing portion (570),
the second deposition material is accommodated in the second vaporizing portion (560) and the fourth vaporizing portion (580),
wherein an angle limiting hole (541), through which the plurality of deposition materials passes, is defined in the angle limiting portion (540), and
the first deposition nozzle (521), the second deposition nozzle (522), the third deposition nozzle (523), and the fourth deposition nozzle (524) overlap the angle limiting hole (541) in a third direction crossing the first direction and the second direction.

7. The evaporation source (500) of claim 5, wherein the plurality of deposition materials includes a first deposition material, a second deposition material, a third deposition material, and a fourth deposition material,
the first deposition material is accommodated in the first vaporizing portion (550),
the second deposition material is accommodated in the second vaporizing portion (560),
the third deposition material is accommodated in the third vaporizing portion (570),
the fourth deposition material is accommodated in the fourth vaporizing portion (580),
wherein a plurality of angle limiting holes (541), through which the plurality of deposition materials passes, is defined in the angle limiting portion (540), and
the first deposition nozzle (521) and the fourth deposition nozzle (524) overlap one of the plurality of angle limiting holes (541) in a third direction crossing the first direction and the second direction, and
the second deposition nozzle (522) and the third deposition nozzle (523) overlap another one of the plurality of angle limiting holes (541) in the third direction.

8. The evaporation source (500) of claim 2, wherein the deposition nozzle assembly (520) is provided in plural,
a plurality of deposition nozzle assemblies is arranged along the second direction,
wherein the angle limiting portion (540) is provided in plural, and
each of a plurality of angle limiting portions (540) is disposed above a corresponding one of the plurality of deposition nozzle assemblies.

9. The evaporation source (500) of any one of the preceding claims, wherein the plurality of vaporizing portions (550) are spaced apart from the main body (510).

10. A deposition apparatus (10) comprising:
a chamber (100);
a substrate holder (200) disposed inside the chamber (100), wherein the substrate holder (200) supports a substrate;
a mask assembly (300) disposed below the substrate; and
an evaporation source (500) according to any one of the preceding claims configured to discharge a plurality of deposition materials to the mask assembly.

11. The deposition apparatus (10) of claim 10, wherein the substrate is a substrate of a display device.

12. A deposition process comprising the steps of:
a) providing a deposition apparatus (10) comprising:
a chamber (100);
a substrate holder (200) disposed inside the chamber (100), wherein the substrate holder (200) supports a substrate;
a mask assembly (300) disposed below the substrate; and
an evaporation source (500) configured to discharge a plurality of deposition materials to the mask assembly (300), wherein the evaporation source (500) includes:
a main body (510);
a deposition nozzle assembly (520) disposed above the main body (510), wherein the deposition nozzle assembly (520) is configured to discharge the plurality of deposition materials;
an angle limiting portion (540) disposed above the deposition nozzle assembly (520), wherein the angle limiting portion (540) is configured to limit a discharge angle of the plurality of deposition materials discharged from the deposition nozzle assembly (520); and
a plurality of vaporizing portions (550) is configured to accommodate the plurality of deposition materials, vaporize the plurality of deposition materials, and supply the vaporized deposition materials to the deposition nozzle assembly (520),
wherein the plurality of vaporizing portions (550) includes a first vaporizing portion (550), a second vaporizing portion (560), a third vaporizing portion (570), and a fourth vaporizing portion (580),
the first vaporizing portion (550) is connected to the first deposition nozzle (521),
the second vaporizing portion (560) is connected to the second deposition nozzle (522),
the third vaporizing portion (570) is connected to the third deposition nozzle (523), and
the fourth vaporizing portion (580) is connected to the fourth deposition nozzle (524), and
wherein the plurality of deposition materials includes a first deposition material, a second deposition material, a third deposition material, and a fourth deposition material,
the first deposition material is accommodated in the first vaporizing portion (550),
the second deposition material is accommodated in the second vaporizing portion (560),
the third deposition material is accommodated in the third vaporizing portion (570),
the fourth deposition material is accommodated in the fourth vaporizing portion (580),
wherein a plurality of angle limiting holes (541), through which the plurality of deposition materials passes, is defined in the angle limiting portion (540), and
the first deposition nozzle (521) and the fourth deposition nozzle (524) overlap one of the plurality of angle limiting holes (541) in a third direction crossing the first direction and the second direction, and
the second deposition nozzle (522) and the third deposition nozzle (523) overlap another one of the plurality of angle limiting holes (541) in the third direction; and
b) moving the substrate in the first direction above the evaporation source (500), and
forming a first deposition layer on a lower portion of the substrate by the first deposition material and the fourth deposition material respectively discharged from the first deposition nozzle (521) and the fourth deposition nozzle (524), and
forming a second deposition layer on a lower portion of the first deposition layer by the second deposition material and the fourth deposition material respectively discharged from the second deposition nozzle (522) and the third deposition nozzle (523).
